# EUROPEAN PATENT APPLICATION

(11) **EP 2 410 558 A2**
(43) Date of publication of application: **25.01.2012**
(21) Application number: 11185392.5
(22) Date of filing: 09.11.2006
(51) Int. Cl.: H01L 21/3105, C09G 1/02, C09K 3/14

(54) **Polishing slurry for silicon oxide, additive liquid and polishing method**

(30) Priority: 11.11.2005 JP 2005327422
(62) Divisional of application: 06823259.4
(71) Applicant: Hitachi Chemical Co., Ltd., Shinjuku-ku Tokyo 163-0449 (JP)
(72) Inventor: Nishiyama, Masaya, Ibaraki, 317-8555 (JP); Fukasawa, Masato, Ibaraki, 317-8555 (JP); Akutsu, Toshiaki, Ibaraki, 317-8555 (JP); Enomoto, Kazuhiro, Ibaraki, 317-8555 (JP); Ashizawa, Toranosuke, Ibaraki, 317-8555 (JP); Ootsuki, Yuuto, Ibaraki, 317-8555 (JP)
(74) Representative: HOFFMANN EITLE

(57) **Abstract**

The present invention concerns the use of a polishing slurry in a method of polishing a silicon oxide film on polysilicon, wherein the polishing slurry contains an abrasive, a polysilicon polishing inhibitor, and water, wherein the polysilicon polishing inhibitor is either an oxyethylene adduct of an acetylene-based diol or the compound represented by the following general formula (III):

R¹-C=C-R² (III)

(in the general formula (III), R¹ represents a hydrogen atom or a substituted or unsubstituted alkyl group having 1 to 5 carbon atoms, R² represents a substituted or unsubstituted alkyl group having 4 to 10 carbon atoms).

## Description

### TECHNICAL FIELD

The invention relates to a polishing slurry preferably used in the planarization process for dielectrics on substrate surfaces, which is a manufacturing technique for semiconductor devices, and particularly relates to a polishing slurry for silicon oxide on polysilicon, an additive liquid used in the polishing slurry, and a polishing method using the polishing slurry.

### BACKGROUND ART

In the present ULSI semiconductor device manufacturing processes, processing techniques for achieving higher density and fineness have been developed. Among them, CMP (Chemical Mechanical Polishing) technique is becoming an essential technique in the manufacturing process for semiconductor devices, for planarization of interlayer dielectrics, shallow trench isolation, formation of plugs or buried metal wiring, and other purposes.

In the manufacturing process for semiconductor devices, as chemical mechanical polishing slurries for the planarization of inorganic dielectric layers, a fumed silica polishing slurry, colloidal silica polishing slurry, and cerium oxide polishing slurry have been generally studied. Examples of inorganic dielectric layers include a silicon oxide dielectric formed by a plasma-CVD method, a low-pressure-CVD method, or other method. Fumed silica is produced from silicon tetrachloride by heat decomposition or other method, and the particles are grown to be used as an abrasive in a polishing slurry. Colloidal silica used to be made from water glass, but alkali components derived from water glass remains in colloidal silica, thus it contains too much metal impurities for semiconductor applications. Afterward, a method for manufacturing colloidal silica from alkoxide was established, which has allowed the manufacture of high purity products, and commercialization of colloidal silica which can be used as an abrasive for semiconductors. In order to use such a silica polishing slurry for polishing silicon oxide for a semiconductor, such as silicon oxide or borosilicate, the pH of the slurry is often adjusted to alkaline for increasing the polishing rate.

On the other hand, cerium oxide particles have lower hardness and are less prone to give scratches on the polishing surface in comparison with silica particles or alumina particles. Further, since cerium oxide polishes silicon oxide at a high polishing rate, the applicable pH range is not particularly limited. In recent years, a CMP polishing slurry using a high purity cerium oxide abrasive is used for semiconductor applications. The technique is, for example, disclosed in Japanese Patent Application Laid-Open No. 10-106994. Another known technique is to add an additive to a cerium oxide polishing slurry for controlling the polishing rate thereof to increase global flatness. The technique is disclosed, for example, in Japanese Patent Application Laid-Open No. 8-22970.

Along with the progress of semiconductor device structures, CMP processes are diversified. After the generation of design rule 0.25 µm, shallow trench isolation is used for isolating devices in an integrated circuit. In shallow trench isolation, CMP is used for removing the surplus parts of a silicon oxide film formed on the substrate. In order to stop polishing by CMP, a stopper film which is polished at a low rate is formed under the silicon oxide film. The stopper film is typically made of silicon nitride, and the polishing rate ratio between the silicon oxide film and the stopper film is preferably large. Such a technique of using a stopper for stopping polishing is used in other applications as well as shallow trench isolation. Besides shallow trench isolation, a stopper may be used, for example, in formation of a plug or the like wherein the surplus parts of a film must be removed by CMP for planarization.

### SUMMARY OF THE INVENTION

Silicon nitride has been commercialized as a stopper for shallow trench isolation because it has high hardness and is readily controllable in polishing rate. Stoppers other than silicon nitride may be possible as long as they are films controllable in their polishing rate. For example, a barrier metal for Cu wiring also serves as a stopper in CMP. In addition, polysilicon (polycrystalline silicon) will be usable as a stopper if the polishing rate thereof is sufficiently controllable.

Polysilicon, which is used as a conductive material for a transistor gate or the like, can be used in different applications from silicon nitride if a CMP technique for using polysilicon as a stopper is established. However, it has been difficult to control polysilicon to a degree where it can be used as a stopper, or to achieve a sufficiently large polishing rate ratio between a film to be polished and polysilicon either with a silica polishing slurry or a cerium oxide polishing slurry.

The object of the invention is to provide a polishing slurry for silicon oxide on polysilicon which achieves a sufficiently large polishing rate ratio between silicon oxide and polysilicon for making polysilicon applicable as a stopper, and a polishing method using the same for polishing a semiconductor substrate or the like.

The invention relates to [1] a polishing slurry for silicon oxide for polishing a silicon oxide film on polysilicon, which contains an abrasive, a polysilicon polishing inhibitor, and water.

Further, the invention relates to [2] the polishing slurry for silicon oxide according to [1], wherein the ratio of the polishing rate for silicon oxide to that for polysilicon is 10 or more.

Further, the invention relates to [3] the polishing slurry for silicon oxide according to [1] or [2], wherein the polysilicon polishing inhibitor is a water-soluble polymer having a N-monosubstituted or N,N-disubstituted skeleton substituted by any member selected from the group consisting of acrylamide, methacrylamide, and α-substituted derivatives thereof.

Further, the invention relates to [4] the polishing slurry for silicon oxide according to [3], wherein the water-soluble polymer is a polymer or copolymer containing at least one selected from the group consisting of a polymerizable monomer represented by the following formula (I) and a polymerizable monomer represented by the following general formula (II).

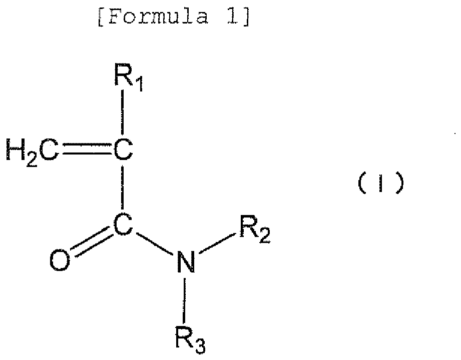

(In the general formula (I), R₁ represents a hydrogen atom, methyl group, phenyl group, benzyl group, chloro group, difluoromethyl group, trifluoromethyl group, or cyano group, and R₂ and R₃ each independently represents a hydrogen atom, alkyl chain of C₁ to C₁₈, methylol group, or acetyl group with the proviso that the case where both of them simultaneously represent a hydrogen atom is excluded.)

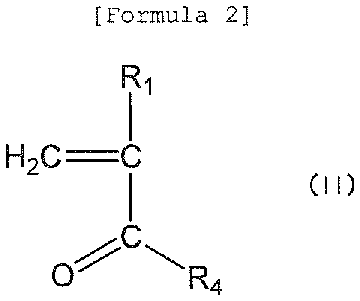

(In the general formula (II), R₁ represents a hydrogen atom, methyl group, phenyl group, benzyl group, chloro group, difluoromethyl group, trifluoromethyl group, or cyano group, R₄ represents a morpholino group, thiomorpholino group, pyrrolidino group, or piperidino group.)
Further, the invention relates to [5] the polishing slurry for silicon oxide according to [1] or [2], wherein the polysilicon polishing inhibitor is polyethylene glycol.

Further, the invention relates to [6] the polishing slurry for silicon oxide according to [1] or [2], wherein the polysilicon polishing inhibitor is an oxyethylene adduct of a acetylene-based diol.

Further, the invention relates to [7] the polishing slurry for silicon oxide according to [1] or [2], wherein the polysilicon polishing inhibitor is at least either of the compound represented by the following general formula (III) and the compound and represented by the following general formula (IV).
[Formula 3]

R¹-C≡C-R² (III)

(In the general formula (III), R¹ represents a hydrogen atom or substituted or unsubstituted alkyl group having 1 to 5 carbon atoms, R² represents a substituted or unsubstituted alkyl group having 4 to 10 carbon atoms.)

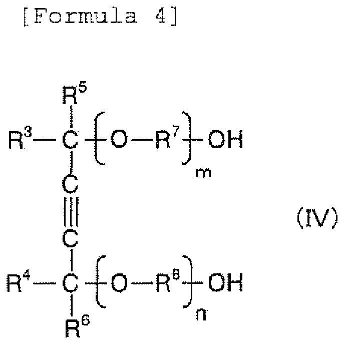

(In the general formula (IV), R³ to R⁶ each independently represent a hydrogen atom or substituted or unsubstituted alkyl group having 1 to 5 carbon atoms, R⁷ and R⁸ each independently represent a substituted or unsubstituted alkylene group having 1 to 5 carbon atoms, and m and n each independently represents 0 or a positive number.)
Further, the invention relates to [8] the polishing slurry for silicon oxide according to [1] or [2], wherein the polysilicon polishing inhibitor is an alkoxylated linear aliphatic alcohol.

Further, the invention relates to [9] the polishing slurry for silicon oxide according to any of [1] through [7], which contains two or more types of the polysilicon polishing inhibitor.

Further, the invention relates to [10] the polishing slurry for silicon oxide according to [9], wherein the polysilicon polishing inhibitor includes two or more compounds selected from the water-soluble polymer, polyethylene glycol, an oxyethylene adduct of an acetylene-based diol, a compound represented by the general formula (III), a compound represented by the general formula (IV), and an alkoxylated linear aliphatic alcohol.

Further, the invention relates to [11] the polishing slurry for silicon oxide according to any of [3] through [10], wherein the content of the polysilicon polishing inhibitor is 0.005% by mass or more and 2% by mass or less.

Further, the invention relates to [12] the polishing slurry for silicon oxide according to any of [3] through [11], wherein the pH is 5.0 to 8.0.

Further, the invention relates to [13] the polishing slurry for silicon oxide according to any of [1] through [12], which contains at least one selected from polyacrylic acid, polyacrylate, and a copolymer containing acrylate.

Further, the invention relates to [14] the polishing slurry for silicon oxide according to any of [1] through [13], wherein the abrasive contains cerium oxide.

Further, the invention relates to [15] the polishing slurry for silicon oxide according to [1] or [2], wherein the polysilicon polishing inhibitor contains polyvinyl pyrrolidone or a copolymer containing vinyl pyrrolidone.

Further, the invention relates to [16] the polishing slurry for silicon oxide according to [15], wherein the content of the polysilicon polishing inhibitor is 0.005 to 5% by mass.

Further, the invention relates to [17] the polishing slurry for silicon oxide according to [15] or [16], wherein the pH is 5.0 to 12.0.

Further, the invention relates to [18] the polishing slurry for silicon oxide according to any of [15] through [17], which contains at least one selected from polyacrylic acid, polyacrylate, and a copolymer containing acrylate.

Further, the invention relates to [19] the polishing slurry for silicon oxide according to any of [15] through [18], wherein the abrasive contains cerium oxide.

Further, the invention relates to [20] the polishing slurry for silicon oxide according to any of [1] through [19], wherein the content of at least one selected from polyacrylic acid, polyacrylate, and a copolymer containing acrylate is 0.01 to 5% by mass.

Further, the invention relates to [21] the polishing slurry for silicon oxide according to any of [1] through [20], wherein the abrasive contains silicon oxide.

Further, the invention relates to [22] a method for polishing a semiconductor substrate using the polishing slurry for silicon oxide according to any of [1] through [21].

Further, the invention relates to [23] an additive liquid for polishing slurry used in a polishing slurry for polishing a silicon oxide film on polysilicon, which contains a polysilicon polishing inhibitor and water.

Further, the invention relates to [24] the additive liquid for polishing slurry according to [23], wherein the polysilicon polishing inhibitor is a water-soluble polymer having a N-monosubstituted or N,N-disubstituted skeleton substituted by any member selected from the group consisting of acrylamide, methacrylamide, and α-substituted derivatives thereof.

Further, the invention relates to [25] the additive liquid for polishing slurry according to [24], wherein the water-soluble polymer is a polymer or copolymer containing at least one selected from the group consisting of a polymerizable monomer represented by the following formula (I) and a polymerizable monomer represented by the following general formula (II).

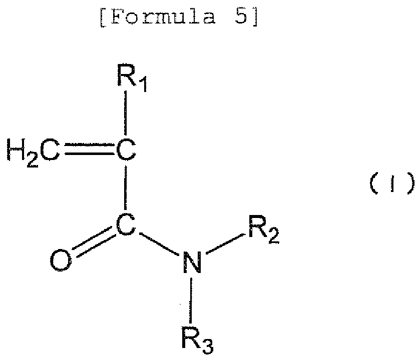

(In the general formula (I), R₁ represents a hydrogen atom, methyl group, phenyl group, benzyl group, chloro group, difluoromethyl group, trifluoromethyl group, or cyano group, and R₂ and R₃ each independently represents a hydrogen atom, alkyl chain of C₁ to C₁₈, methylol group, or acetyl group with the proviso that the case where both of them simultaneously represent a hydrogen atom is excluded.)

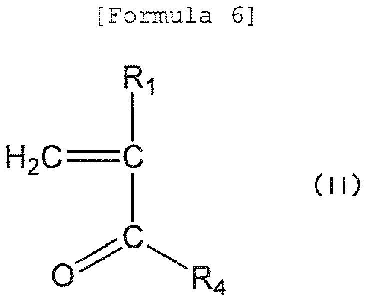

(In the general formula (II), R₁ represents a hydrogen atom, methyl group, phenyl group, benzyl group, chloro group, difluoromethyl group, trifluoromethyl group, or cyano group, R₄ represents a morpholino group, thiomorpholino group, pyrrolidino group, or piperidino group.)
Further, the invention relates to [26] the additive liquid for polishing slurry according to [23], wherein the polysilicon polishing inhibitor is polyethylene glycol.

Further, the invention relates to [27] the additive liquid for polishing slurry according to [23], wherein the polysilicon polishing inhibitor is an oxyethylene adduct of an acetylene-based diol.

Further, the invention relates to [28] the additive liquid for polishing slurry according to [23], wherein the polysilicon polishing inhibitor is at least either of the compound represented by the following general formula (III) and the compound and represented by the following general formula (IV).
[Formula 7]

R¹-C≡C-R² (III)

(In the general formula (III), R¹ represents a hydrogen atom or substituted or unsubstituted alkyl group having 1 to 5 carbon atoms, R² represents a substituted or unsubstituted alkyl group having 4 to 10 carbon atoms.)

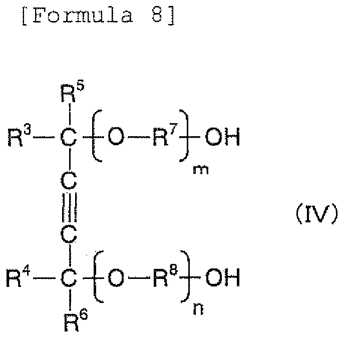

(In the general formula (IV), R³ to R⁶ each independently represent a hydrogen atom or substituted or unsubstituted alkyl group having 1 to 5 carbon atoms, R⁷ and R⁸ each independently represent a substituted or unsubstituted alkylene group having 1 to 5 carbon atoms, and m and n each independently represents 0 or a positive number.)
Further, the invention relates to [29] the additive liquid for polishing slurry according to [23], wherein the polysilicon polishing inhibitor is an alkoxylated linear aliphatic alcohol.

Further, the invention relates to [30] the additive liquid for polishing slurry according to [23], which contains two or more types of the polysilicon polishing inhibitor.

Further, the invention relates to [31] the additive liquid for polishing slurry according to [30], wherein the polysilicon polishing inhibitor includes two or more compounds selected from the water-soluble polymer, polyethylene glycol, an oxyethylene adduct of an acetylene-based diol, a compound represented by the general formula (III), a compound represented by the general formula (IV), and an alkoxylated linear aliphatic alcohol.

Further, the invention relates to [32] the additive liquid for polishing slurry according to any of [23] through [31], which further contains at least one selected from polyacrylic acid, polyacrylate, and a copolymer containing acrylate.

Further, the invention relates to [33] a polishing method using the polishing slurry for silicon oxide according to any of [1] through [21], wherein the object to be polished is held against a polishing pad with the surface thereof to be polished facing the polishing pad, and polished by being slid relative to the polishing pad while the polishing slurry is supplied between the polishing pad and the surface to be polished.

The invention provides a polishing slurry and a polishing method which are capable of polishing a silicon oxide film on a polysilicon film at a high speed, and inhibiting the progress of polishing of a polysilicon film in exposed parts in a CMP technique in the manufacturing process of a semiconductor in which a silicon oxide film is polished.

Disclosure of the invention is related to the subject described in Japanese Patent Application No. 2005-327422 which was filed on November 11, 2005, and the disclosure of which is incorporated herein by reference.

### BEST MODE OF CARRYING OUT THE INVENTION

The embodiment of the invention is described in detail below.

As a result of the eager investigation by the inventors of the present invention concerning the polishing of a silicon oxide film on a polysilicon film in the planarization process of a semiconductor, it has been found that a polishing slurry comprising an abrasive, water, and a inhibitor for inhibiting polishing of a polysilicon film is capable of keeping a high polishing rate for a silicon oxide film and a low polishing rate for a polysilicon film, and thereby achieving a high polishing rate ratio (selective ratio) between them. Thus the present invention has been accomplished. It has been also found that the selective ratio is increased by adjusting the pH of the polishing slurry.

The abrasive used in the invention may be cerium oxide, silicon oxide, or the like, and is preferably cerium oxide. Cerium oxide particles are not limited as to their manufacturing method, but the average primary particle diameter of cerium oxide is preferable 5 nm or more and 300 nm or less. This is because, regarding a cerium oxide polishing slurry used for polishing of a silicon oxide film formed by a TEOS-CVD method or the like, cerium oxide having a larger primary particle diameter and less crystal distortion or higher crystallinity allows faster polishing, but tends to give polishing scratches. The term primary particles refers to particles corresponding to crystallites surrounded by grain boundaries which are measured and observed with a SEM (scanning electron microscope).

In the invention, the method for preparing cerium oxide powder may be sintering of a cerium compound such as carbonate, nitrate, sulfate, or oxalate, or oxidation with hydrogen peroxide or the like. The sintering temperature is preferably 350°C or higher and 900°C or lower. Since cerium oxide particles prepared by the above-described methods tend to cause aggregation, they are preferably pulverized by a mechanical means. As a pulverizingmethod, a dry milling method by a jet mill or the like, or a wet milling method with a planet bead mill or the like is preferable.

The median value of the secondary particle diameter of the abrasive is preferably 0.03 to 0.5 µm, and more preferably 0.05 to 0.3 µm. This is because that if the median value of the secondary particle diameter is less than 0.03 µm, the polishing rate tends to be low, and if more than 0. 5 µm, the abrasive tends to give polishing scratches on the film surface to be polished.

The abrasive is dispersed in water to obtain a slurry. The method for dispersion may be dispersion with an ordinary stirrer, or may use a homogenizer, ultrasonic disperser, wet ball mill or the like.

The concentration of the abrasive in the polishing slurry is not limited, but preferably in the range of 0.1% by mass or more and 20% by mass or less, more preferably in the range of 0.2% by mass or more and 10% by mass or less, and particularly preferably in the range of 0.5% by mass or more and 5% by mass or less from the viewpoint of manageability of the dispersion liquid (slurry).

The slurry may contain a dispersant for the abrasive. Since the dispersant for the abrasive is used for polishing of a semiconductor device, the content of alkali metals such as sodium and potassium ions, halogens, and sulfur in the dispersant is preferably 10 ppm or less. A preferable example is a polymer dispersant containing an acrylic acid ammonium salt as a copolymerization component.

The addition amount of the dispersant is preferably in the range of 0.01 parts by mass or more and 5.0 parts by mass or less relative to 100 parts by mass of the abrasive particles in consideration of the relationship between the dispersibility of the particles in the polishing slurry and prevention of settling, and the relationship between polishing scratches and the addition amount of the dispersant. The weight average molecular weight of the dispersant is preferably 100 to 50,000, and more preferably 1,000 to 10,000. This is because if the molecular weight of the dispersant is less than 100, a sufficient polishing rate is hard to be achieved during polishing of a silicon oxide film, and if the molecular weight of the dispersant is more than 50,000, the viscosity tends to be high, and the preservation stability of the polishing slurry tends to decrease. The weight average molecular weight is a value determined by gel permeation chromatography, and converted to standard polystyrene.

Since the abrasive in the thus prepared polishing slurry for silicon oxide of the invention (hereinafter also referred to as polishing slurry) has a particle diameter distribution, 99% by volume (D99) of the whole particles is preferably 1.0 µm or less. If D99 is more than 1.0 µm, many scratches (polishing scratches) may occur.

The median value of the secondary particle diameter of the abrasive in the polishing slurry) may be determined by a light scatteringmethodusing, for example, aparticlesizeanalyzer (e.g., Mastersizer Micro Plus, manufactured by Malvern Instruments).

The content of coarse particles of 3 µm or more in the total solid content in the polishing slurry is preferably lower. When the content of particles of 3 µm or more is 500 ppm or less relative to the total solid content, it is preferable because the scratch reduction effect is evident. When the content of particles of 3 µm or more is 200 ppm or less relative to the total solid content, it is more preferable because the scratch reduction effect is higher. When the content of particles of 3 µm or more is 100 ppm or less relative to the total solid content, it is further preferable because the scratch reduction effect is highest.

The content of large particles of 3 µm or more is determined by mass determination of particles captured by a filter having pore diameter of 3 µm. The means for reducing the content of large particles may be filtration or classification, but is not limited to them.

The polysilicon film polishing inhibitor of the invention is preferably a nonionic water-soluble polymer. The reason is as follows: in a measurement of zeta potential on the surface of a silicon oxide film, which is to be polished by the polishing slurry of the invention, a negative zeta potential of about -20 mV or less is indicated in a large pH range, while a polysilicon (polycrystalline silicon) film, which is to be hindered from being polished, has a pH of 8 or less and a zeta potential of about -10 mV or less, which is relatively close to 0. A nonionic water-soluble polymer is considered to more readily adhere to the surface of a polysilicon film than the surface of a silicon oxide film.

The weight average molecular weight of the water-soluble polymer is preferably 500 or more and 3,000,000 or less, and more preferably 1,000 or more and 1,000,000 or less. This is based on the assumption that those having a higher weight average molecular weight are more effective in inhibiting polishing upon adhesion to the surface of a polysilicon film. However, if the weight average molecular weight is excessive, the viscosity of the polishing slurry increases, which causes defects such as sedimentation of the abrasive. Accordingly, the lower limit is preferably 500 or more, more preferably 1, 000 or more, and particularly preferably 2, 000 or more. The upper limit is preferably 50, 000 or less, more preferably 20,000 or less, and particularly preferably 10,000 or less.

Typical examples of the polysilicon film polishing inhibitor include water-soluble polymers group having a N-monosubstituted or N,N-disubstituted skeleton substituted by any member selected from the group consisting of acrylamide, methacrylamide, and α-substituted derivatives thereof.

Among the water-soluble polymers, a polymer or copolymer using at least one selected from the polymerizable monomer represented by the following general formulae (I) and (II) is preferable. Also preferable is a copolymer using both of the polymerizable monomers represented by the general formulae (I) and (II) . The polymerizable monomers represented by the general formulae (I) and (II) may be copolymerized with other polymerizable monomers such as acrylic acid, acrylic esters of C₁ to C₁₈, methacrylic acid, methacrylic acid esters of C₁ to C₁₈, acrylamide, vinyl alcohol, acrylonitrile, vinyl pyrrolidone, vinyl pyridine, vinyl acetate, maleic acid, fumaric acid, itaconic acid, and p-styrenecarboxylic acid. The polymer or copolymer preferably has a weight average molecular weight of 500 or more, and is preferably prepared by radical polymerization or the like.

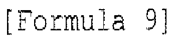

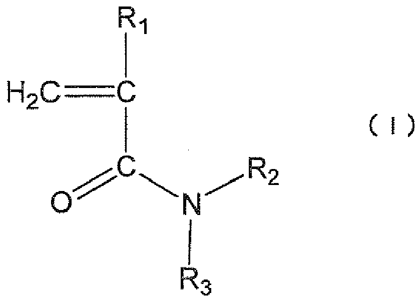

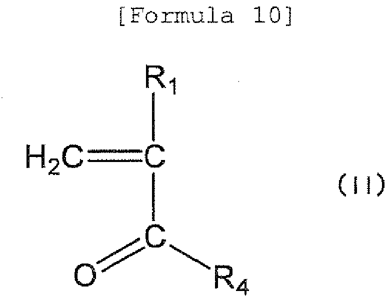

In the general formula (I), R₁ represents a hydrogen atom, methyl group, phenyl group, benzyl group, chloro group, difluoromethyl group, trifluoromethyl group, or cyano group, and R₂ and R₃ each independently represents a hydrogen atom, alkyl chain of C₁ to C₁₈, methylol group, or acetyl group with the proviso that the case where both of them simultaneously represent a hydrogen atom is excluded. In the general formula (II), R₁ represents hydrogen atom, methyl group, phenyl group, benzyl group, chloro group, difluoromethyl group, trifluoromethyl group, or cyano group, R₄ represents a morpholino group, thiomorpholino group, pyrrolidino group, or piperidino group.

Examples of the water-soluble polymer having a N-monosubstituted or N,N-disubstituted skeleton include: compounds having a N-monosubstituted skeleton such as N-methylacrylamide, N-ethylacrylamide, N-propylacrylamide, N-isopropylacrylamide, N-butylacrylamide, N-isobutylacrylamide, N-tertiarybutylacrylamide, N-heptylacrylacrylamide, N-octylacrylamide, N-tertiaryoctylacrylamide, N-dodecylacrylamide, N-octadecylacrylamide, N-methylolacrylamide, N-acetylacrylamide, N-diacetone acrylamide, N-methylmethacrylamide, N-ethylmethacrylamide, N-propylmethacrylamide, N-isopropylmethacrylamide, N-butylmethacrylamide, N-isobutylmethacrylamide, N-tertiarybutylmethacrylamide, N-heptylmethacrylamide, N-octylmethacrylamide, N-tertiaryoctylmethacrylamide, N-dodecylmethacrylamide, N-octadecylmethacrylamide, N-methylolmethacrylamide, N-acetylmethacrylamide, and N-diacetone methacrylamide; and compounds having a N,N-disubstituted skeleton such as N,N-dimethylacrylamide, N,N-diethylacrylamide, N,N-dipropylacrylamide, N,N-diisopropylacrylamide, N,N-dibutylacrylamide, N,N-diisobutylacrylamide, N,N-ditertiarybutylacrylamide, N,N-diheptylacrylamide, N,N-dioctylacrylamide, N,N-ditertiaryoctylacrylamide, N,N-didodecylacrylamide, N,N-dioctadecylacrylamide, N,N-dimethylolacrylamide, N,N-diacetylacrylamide, N,N-diacetone acrylamide, N,N-dimethylmethacrylamide, N,N-diethylmethacrylamide, N,N-dipropylmethacrylamide, N,N-diisopropylmethacrylamide, N,N-dibutylmethacrylamide, N,N-diisobutylmethacrylamide, N,N-ditertiarybutylmethacrylamide, N,N-diheptylmethacrylamide, N,N-dioctylmethacrylamide, N,N-ditertiaryoctylmethacrylamide, N,N-didodecylmethacrylamide, N,N-dioctadecylmethacrylamide, N,N-dimethylolmethacrylamide, N,N-diacetylmethacrylamide, N,N-diacetone methacrylamide, acryloylpiperidine, acryloylmorpholine, acryloylthiomorpholine, and acryloylpyrrolidine. These compounds may be used alone or in combination of two or more of them.

Other examples of the polysilicon film polishing inhibitor of the invention include polyethylene glycol which is a water-soluble polymer.

Other examples of the polysilicon film polishing inhibitor of the invention also include an oxyethylene adduct of an acetylene-based diol which is a water-soluble polymer. Examples of the oxyethylene adduct of an acetylene-based diol include compounds such as 2,4,7,9-tetramethyl-5-decyne-4,7-diol, 2,4,7,9-tetramethyl-5-decyne-4,7-diol-dipolyoxyethylene ether, and 2,4,7,9-tetramethyl-5-decyne-4,7-diol-monopolyoxyethylene ether. Among them, 2,4,7,9-tetra methyl-5-decyne-4,7-diol-dipolyoxyethylene ether is particularly preferable from the viewpoint of both of water solubility and decrease of surface tension.

Other examples of the polysilicon film polishing inhibitor of the invention also include a compound represented by the following general formula (III) and/or an organic compound having an acetylene bond represented by the following general formula (IV).
[Formula 11]

R¹-C≡C-R² (III)

(In the general formula (III), R¹ represents a hydrogen atom or substituted or unsubstituted alkyl group having 1 to 5 carbon atoms, R² represents a substituted or unsubstituted alkyl group having 4 to 10 carbon atoms.)

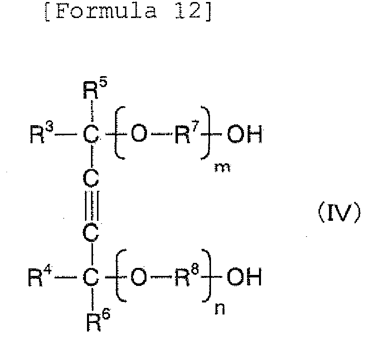

(In the general formula (IV), R³ to R⁶ each independently represent a hydrogen atom or substituted or unsubstituted alkyl group having 1 to 5 carbon atoms, R⁷ and R⁸ each independently represent a substituted or unsubstituted alkylene group having 1 to 5 carbon atoms, and m and n each independently represents 0 or a positive number.)
Other examples of the polysilicon film polishing inhibitor of the invention also include an alkoxylated linear aliphatic alcohol.

The pH of the polishing slurry using the polysilicon film polishing inhibitor is preferably 5.0 or more and 8.0 or less, and more preferably 6.0 or more and 7.0 or less. If the pH is less than 5, the polishing rate for a polysilicon film tends to increase, and if the pH is more than 8, the polishing rate for a silicon oxide film tends to decrease.

In the invention, the pH of the polishing slurry is measured as follows: two-point calibration is performed using standard buffer solutions (phthalate pH buffer solution having a pH of 4.21 (25°C) and a neutral phosphate pH buffer solution having a pH of 6. 86 (25°C)) with a pH meter (e.g., model number PH81 manufactured by Yokogawa Electric Corporation), subsequently the electrode is immersed in the polishing slurry, and the pH is measured after it becomes stable after a lapse of at least two minutes. The pH may be adjusted with an alkaline component or acid such as ammonia or tetramethyl ammonium hydroxide (TMAH).

The polysilicon film polishing inhibitor may be used alone, but preferably in combination of two or more of them, and particularly preferably contains two or more members selected from the water-soluble polymer compound having a N-monosubstituted or N,N-disubstituted skeleton substituted by any member selected from the group consisting of acrylamide, methacrylamide, and α-substituted derivatives thereof, polyethylene glycol, an oxyethylene adduct of an acetylene-based diol, a compound represented by the general formula (III), a compound represented by the general formula (IV), and an alkoxylated linear aliphatic alcohol.

The addition amount of the polysilicon film polishing inhibitor is preferably in the range of 0.005% by mass or more and 2% by mass or less relative to 100 parts by mass of the polishing slurry, or 0. 005 to 2% by mass in the polishing slurry. If the amount is less than 0.005% by mass, the inhibitory effect on polishing of a polysilicon film is low, and if more than 2% by mass, the polishing rate for a silicon oxide film may decrease, and flowability may deteriorate due to gelation.

Examples of other polysilicon film polishing inhibitors which may be used in the invention include polyvinyl pyrrolidone or copolymers containing vinyl pyrrolidone (hereinafter they are collectively referred to as polyvinyl pyrrolidones). The addition amount of polyvinyl pyrrolidones is preferably in the range of 0.005% by mass or more and 5% by mass or less relative to the polishing slurry. The weight average molecular weight of polyvinyl pyrrolidones is preferably 10,000 to 1,200,000. If the molecular weight is less than 10,000, planarization property tends to be insufficient, and if more than 1,200,000, the abrasive tends to cause aggregation. The pH of the polishing slurry using a polyvinyl pyrrolidone is preferably 5.0 or more and 12.0 or less, and more preferably 6.0 or more and 7.0 or less. If the pH is less than 5.0, the polishing rate for a polysilicon film tends to be excessive, and if the pH is more than 12, the polishing rate for a polysilicon film tends to decrease. The polyvinyl pyrrolidones may be combined with the above-described polysilicon film polishing inhibitor.

The polishing slurry of the invention may be combined with other water-soluble polymers. Examples of the other water-soluble polymers are not particularly limited, and include polysaccharides such as alginic acid, pectin acid, carboxy methyl cellulose, agar, curdlan and pullulan; polycarboxylic acids and salts thereof such as polyasparatic acid, polyglutamic acid, polylysine, polymalic acid, polymethacrylic acid, polymethacrylic acid ammonium salt, polymethacrylic acid sodium: salt, polyamide acid, polymaleic acid, polyitaconic acid, polyfumaric acid, poly(p-styrene carboxylic acid), polyacrylic acid, polyacrylamide, amino polyacrylamide, polyacrylic acid ammonium salt, sodium polyacrylate salt, polyamide acid, polyamide acid ammonium salt, polyamide acid sodium salt, and polyglyoxalic acid; and vinyl polymers such as polyvinyl alcohol and polyacrolein. The weight average molecular weight is preferably 500 or more, and preferably 50, 000 or less for avoiding the occurrence of excessive viscosity and deterioration of the preservation stability of the polishing slurry.

In particular, it is preferable to use at least one selected from polyacrylic acid, polyacrylate, and copolymer containing acrylate as an additive for improving the flatness of the oxide film surface. The addition amount of the polyacrylic acid, polyacrylate, and copolymer containing acrylate is preferably in the range of 0.01% by mass or more and 5% by mass or less relative to 100 parts by mass of the polishing slurry. This is because that if the amount is less than 0.01% by mass, the effect of improving the flatness is low, and if more than 5% by mass, the abrasive tends to cause aggregation.

Further, the polysilicon film polishing inhibitor may be combined with the additive for improving global flatness. More specifically, the water-soluble polysilicon film polishing inhibitor will not cause any problem even if it is combined with an additive for improving flatness containing a copolymer containing polyacrylic acid, polyacrylate, or acrylate.

The additive liquid for polishing slurry of the invention is an additive liquid for polishing slurry used in a polishing slurry for polishing a silicon oxide film on polysilicon, and contains a polysilicon polishing inhibitor and water.

The polishing slurry for silicon oxide of the invention may be preserved as a two-liquid polishing slurry in which a slurry containing an abrasive and water is separated from an additive liquid containing a polysilicon polishing inhibitor and water, or may be preserved as a one-liquid polishing slurry containing an additive liquid or a polysilicon polishing inhibitor. When the polishing slurry is preserved as a two-liquid polishing slurry, its planarization property and polishing rate can be adjusted by arbitrarily changing the formulation of the two-liquids. When a substrate is polished with the two-liquid polishing slurry, the additive liquid and the slurry are sent in different lines, and the lines are merged into one to mix the liquids immediately before the outlet of the feeding line, and the mixture is supplied onto the polishing platen, or the additive is mixed with the slurry immediately before polishing. For two-liquid polishing slurries, the additive for improving flatness is preferably contained in the additive liquid.

Examples of the method for preparing a silicon oxide film which can be polished with the polishing slurry of the invention include a low-pressure CVD method and a plasma CVD method. Formation of a silicon oxide film by the low-pressure CVD method is achieved by an oxidation reaction of SiH₄-O₂ system at a low temperature of 400°C or lower using monosilane (SiH₄) as an Si source, and oxygen (O₂) as an oxygen source. According to circumstances, CVD may be followed by heat treatment at a temperature of 1000°C or lower. When phosphorus (P) is doped in order to planarize the surface by high-temperature reflowing, it is preferable to use a reaction gas of SiH₄-O₂-PH₃ system. The plasma CVD method has an advantage that any chemical reaction which requires a high temperature under normal heat equilibrium can be carried out at a low temperature. There are two types of methods for generating plasma: capacitive coupling type and inductive coupling type. Examples of the reaction gas include a gas of SiH₄-N₂O system using SiH₄ as an Si source and N₂O as an oxygen source, and a gas of TEOS-O₂ system using tetraethoxysilane (TEOS) as an Si source (TEOS-plasma CVD method). The substrate temperature is preferably in the range of 250 to 400°C, and the reaction pressure is preferably in the range of 67 to 400 Pa. Thus, the silicon oxide filmmay be doped with an element such as phosphorus or boron.

In the same manner, formation of a polysilicon film by the CVD method is performed using SiH₄ as an Si source at a substrate temperature of 600 to 1000°C.

The polishing method of the invention is a method for polishing an object to be polished, wherein the object to be polished is held against a polishing pad with its surface to be polished facing the polishing pad, and polished by being slid relative to the polishing pad while a polishing slurry is supplied between the polishing pad and the surface to be polished, and the polishing slurry for silicon oxide of the invention is used as the polishing slurry. Examples of the object to be polished include a substrate involved in the manufacture of a semiconductor device, for example a substrate comprising a polysilicon film having formed thereon a silicon oxide film.

The ratio of the polishing rate for a silicon oxide film to the polishing rate for a polysilicon film (selective ratio) is preferably 10 or more from the viewpoint of easy stop control of polishing. The polishing rate for a silicon oxide film is preferably 50 nm/min or more, and more preferably 100 nm/min or more. The polishing rate for polysilicon is preferably 10 nm/min or less, and more preferably 5 nm/min or less. The polishing apparatus may be a common polishing apparatus comprising a holder for holding a substrate and a platen equipped with a motor or the like with variable rotation number, to which a polishing cloth (pad) can be attached. The polishing cloth may be a common nonwoven fabric, foamed polyurethane, or porous fluorocarbon resin, and is not particularly limited. The polishing cloth is preferably groove-processed for retaining the polishing slurry.

The polishing conditions are not limited, but the rotation rate of the platen is preferably as lows as 200 min⁻¹ or less for preventing the substrate from jumping out, and the pressure to be applied to the substrate is preferably 9.8 × 10⁴ Pa or less in order to prevent the development of scratches. During polishing, the polishing slurry is continuously supplied to the polishing cloth with a pump or the like. The amount of the polishing slurry to be supplied is not particularly limited, but is preferably in an amount so that the surface of the polishing cloth is constantly covered with the polishing slurry. The substrate after completion of polishing is preferably thoroughly washed in running water, and dried after water droplets adhering to the substrate are knocked off with a spin dryer or the like.

### EXAMPLES

The invention is further illustrated by following Examples. The invention is not limited to these Examples.

### (Preparation of cerium oxide particles)

2 kg of cerium carbonate hydrate was placed in a container made of platinum, followed by sintering at 800°C for 2 hours in air to obtain about 1 kg of a yellowish white powder. Phase identification of this powder was made by X-ray diffractometry to confirm that it was cerium oxide. The sintered powder had particle diameters of 30 to 100 µm. The surface of the sintered particles was observed with a scanning electron microscope, where grain boundaries of cerium oxide were seen. Diameters of cerium oxide primary particles surrounded by the grain boundaries were measured to find that the median diameter and maximum diameter in their particle size distribution were 190 nm and 500 nm, respectively. 1 kg of the cerium oxide powder was pulverized by a dry process with a jet mill. The pulverized particles were observed with a scanning electron microscope to find that large pulverization residue particles of 1 µm to 3 µm and pulverization residue particles of 0. 5 µm to 1 µm were present in a mixed state in addition to small particles having the same size as the primary particle diameter.

### (Preparation of cerium oxide slurry)

1 kg of the cerium oxide particles prepared above was mixed with 23 g of an aqueous solution of polyacrylic acid ammonium salt (40% by mass) and 8977 g of deionized water, followed by ultrasonic dispersion for 10 minutes while being stirred. The obtained slurry was filtered through a 1-micron filter, and followed by further addition of deionized water to obtain a 5% by mass slurry. The slurry had a pH of 8.3. The slurry was diluted to an appropriate concentration in order to examine the slurry particles with a laser diffraction particle size analyzer to find that the median value of the particle diameter was 190 nm.

### (Procurement of water-soluble polymer)

### Water-soluble polymer 1

Polyvinyl pyrrolidone manufactured by Wako Pure Chemical Industries, Ltd. (reagent, K-30) was procured.

### Water-soluble polymer 2

Polyvinyl pyrrolidone manufactured by Wako Pure Chemical Industries, Ltd. (reagent, K-90) was procured.

### Water-soluble polymer 3-1 [Synthesis example 1]

280 g of deionized water and 20 g of 2-propanol were placed in a 1-L flask, heated to 90°C while being stirred in a nitrogen gas atmosphere, followed by injection of a solution of 1 g of a polymerization initiator (trade name: V-601, manufactured by Wako Pure Chemical Industries, Ltd.) in 100 g acryloyl morpholine over a period of 2 hours. Subsequently the flask was incubated at 90°C for 5 hours, cooled, and taken out to obtain a water-soluble polymer solution. The concentration of the water-soluble polymer in the solution was 25.3%.

### Water-soluble polymer 3-2 [Synthesis example 2]

Synthesis was carried out using 50 g of N,N-diethylacrylamide and 50 g of acryloyl morpholine by the method of Synthesis example 1 to obtain a water-soluble polymer solution. The concentration of the water-soluble polymer in the solution was 25.1%.

### Water-soluble polymer 3-3 [Synthesis example 3]

Synthesis was carried out using 50 g of N, N-diethylacrylamide and 50 g of N,N-dimethylacrylamide by the method of Synthesis example 1 to obtain a water-soluble polymer solution. The concentration of the water-soluble polymer in the solution was 25.0%.

### Water-soluble polymer 3-4 [Synthesis example 4]

Synthesis was carried out using 100 g of N, N-dimethylacrylamide by the method of Synthesis example 1 to obtain a water-soluble polymer solution. The concentration of the water-soluble polymer in the solution was 25.1%.

### Water-soluble polymer 4

Polyethylene glycol manufactured by Dai-Ichi Kogyo Seiyaku Co., Ltd. (reagent, PEG-4000) was procured.

### Water-soluble polymer 5

As an oxyethylene adduct of an acetylene-based diol, 2,4,7,9-tetramethyl-5-decyne-4,7-diol was procured.

### Water-soluble polymer 6

As an alkoxylated linear aliphatic alcohol, a reagent manufactured by BASF (LF-401) was procured.

### Water-soluble polymer 7

Polyacrylic acid (trade name: JULIMER AC-10S, manufactured by Nihonjunyaku Co., Ltd.) was procured.

### (Preparation of polishing slurry)

### Polishing slurry 1

600 g of the cerium oxide slurry prepared above (solid content: 5% by mass) was mixed with 1 g of polyvinyl pyrrolidone of the water-soluble polymer 1 as a polysilicon film polishing inhibitor and 2399 g of deionized water to obtain a polishing slurry (cerium oxide: 1% by mass). The polishing slurry was adjusted to pH 6.5 with a trace amount of nitric acid.

### Polishing slurry 2

600 g of the cerium oxide slurry prepared above (solid content: 5% by mass) was mixed with 2 g of polyvinyl pyrrolidone of the water-soluble polymer 2 as a polysilicon film polishing inhibitor and 2398 g of deionized water to obtain a polishing slurry (cerium oxide: 1% by mass). The polishing slurry was adjusted to pH 6.5 with a trace amount of nitric acid.

### Polishing slurry 3

600 g of the cerium oxide slurry prepared above (solid content: 5% by mass) was mixed with 0.5 g of polyvinyl pyrrolidone of the water-soluble polymer 1 as a polysilicon film polishing inhibitor, 70 g of a solution of the water-soluble polymer 7 as a highly planarizing agent for oxide film, and 2329.5 g of deionized water to obtain a polishing slurry (cerium oxide: 1% by mass). The polishing slurry was adjusted to pH 6.5 with a trace amount of ammonia.

### Polishing slurry 4

600 g of the cerium oxide slurry prepared above (solid content: 5% by mass) was mixed with 20 g of a solution of the water-soluble polymer 3-1 (synthesis example 1) as a polysilicon polishing inhibitor and 2380 g of deionized water to obtain a polishing slurry (cerium oxide: 1% by mass). The polishing slurry was adjusted to pH 6.5 with a trace amount of nitric acid.

### Polishing slurry 5

A polishing slurry was prepared in the same manner as polishing slurry 4 except that a solution of the water-soluble polymer 3-2 (synthesis example 2) was used as a polysilicon polishing inhibitor in place of the water-soluble polymer 3-1 (synthesis example 1).

### Polishing slurry 6

A polishing slurry was prepared in the same manner as polishing slurry 4 except that a solution of the water-soluble polymer 3-3 (synthesis example 3) was used as a polysilicon polishing inhibitor in place of the water-soluble polymer 3-1 (synthesis example 1).

### Polishing slurry 7

A polishing slurry was prepared in the same manner as polishing slurry 4 except that a solution of the water-soluble polymer 3-4 (synthesis example 4) was used as a polysilicon polishing inhibitor in place of the water-soluble polymer 3-1 (synthesis example 1).

### Polishing slurry 8

600 g of the cerium oxide slurry prepared above (solid content: 5% by mass) was mixed with 10 g of a solution of the water-soluble polymer 3-1(synthesis example 1) as a polysilicon film polishing inhibitor, 70 g of a solution of the water-soluble polymer 7 as a highly planarizing agent for oxide film, and 2320 g of deionized water to obtain a polishing slurry (cerium oxide: 1% by mass) . The polishing slurry was adjusted to pH 6.5 with a trace amount of ammonia.

### Polishing slurry 9

A polishing slurry was prepared in the same manner as polishing slurry 8 except that a solution of the water-soluble polymer 3-4 (synthesis example 4) was used as a polysilicon polishing inhibitor in place of the water-soluble polymer 3-1 (synthesis example 1).

### Polishing slurry 10

600 g of the cerium oxide slurry prepared above (solid content: 5% by mass) was mixed with 5 g of a solution of the water-soluble polymer 4 as a polysilicon film polishing inhibitor, 70 g of a solution of the water-soluble polymer 7 as a highly planarizing agent for oxide film, and 2325 g of deionized water to obtain a polishing slurry (cerium oxide: 1% by mass) . The polishing slurry was adjusted to pH 6.5 with a trace amount of ammonia.

### Polishing slurry 11

600 g of the cerium oxide slurry prepared above (solid content: 5% by mass) was mixed with 5 g of a solution of the water-soluble polymer 5 as a polysilicon filmpolishing inhibitor, 70 g of a solution of the water-soluble polymer 7 as a highly planarizing agent for oxide film, and 2325 g of deionized water to obtain a polishing slurry (cerium oxide: 1% by mass). The polishing slurry was adjusted to pH 6.5 with a trace amount of ammonia.

### Polishing slurry 12

600 g of the cerium oxide slurry prepared above (solid content: 5% by mass) was mixed with 5 g of a solution of the water-soluble polymer 6 as a polysilicon filmpolishing inhibitor, 70 g of a solution of the water-soluble polymer 7 as a highly planarizing agent for oxide film, and 2325 g of deionized water to obtain a polishing slurry (cerium oxide: 1% by mass) . The polishing slurry was adjusted to pH 6.5 with a trace amount of ammonia.

### Polishing slurry 13

600 g of the cerium oxide slurry prepared above (solid content: 5% by mass) was mixed with 2400 g of deionized water to obtain a polishing slurry (cerium oxide: 1% by mass). The polishing slurry was adjusted to pH 6.5 with a trace amount of ammonia.

### Polishing slurry 14

600 g of the cerium oxide slurry prepared above (solid content: 5% by mass) was mixed with 70 g of a solution of the water-soluble polymer 7 as a highly planarizing agent for oxide film and 2320 g of deionized water to obtain a polishing slurry (cerium oxide: 1% by mass). The polishing slurry was adjusted to pH 6.5 with a trace amount of ammonia.

### Polishing slurry 15

600 g of the cerium oxide slurry prepared above (solid content: 5% by mass) was mixed with 12 g of a solution of the water-soluble polymer 3-1 (synthesis example 1) as a polysilicon polishing inhibitor and 2388 g of deionized water to obtain a polishing slurry (cerium oxide: 1% by mass). The polishing slurry was adjusted to pH 4.5 with a trace amount of nitric acid.

### Polishing slurry 16

600 g of the cerium oxide slurry prepared above (solid content: 5% by mass) was mixed with 60 g of a solution of the water-soluble polymer 3-1 (synthesis example 1) as a polysilicon polishing inhibitor and 2340 g of deionized water to obtain a polishing slurry (cerium oxide: 1% by mass). The polishing slurry was adjusted to pH 9.0 with a trace amount of ammonia.

### Polishing slurry 17

600 g of the cerium oxide slurry prepared above (solid content: 5% by mass) was mixed with 2400 g of deionized water to obtain a polishing slurry (cerium oxide: 1% by mass). The polishing slurry was adjusted to pH 4.5 with a trace amount of nitric acid.

### Polishing slurry 18

600 g of the cerium oxide slurry prepared above (solid content: 5% by mass) was mixed with 2400 g of deionized water to obtain a polishing slurry (cerium oxide: 1% by mass). The polishing slurry was adjusted to pH 9.0 with a trace amount of ammonia. Tables 1 through 3 show the composition and pH of the polishing slurries.

### (Evaluation of polishing)

### Example 1

The substrate below was subjected to CMP polishing under following conditions while a polishing slurry of the polishing slurry 1 was dropped on the pad attached to the platen, and evaluated as described below.

### <Substrates for evaluation>

Substrate 1: A blanket substrate of 8 inch diameter comprising a Si substrate having formed thereon a silicon oxide film (P-TEOS) of 0.8 µm thickness.

Substrate 2: A blanket substrate of 8 inch diameter comprising a Si substrate having formed thereon a silicon oxide film of 0.1 µm thickness and a polysilicon film of 0.4 µm thickness in this order.

### <Evaluation conditions>

Polishing apparatus: MIRRA polishing machine, manufactured by AMAT, platen diameter 600 mm, rotary type
Polishing pad: IC-1000/Suba 400 manufactured by Nitta Haas Incorporated, foamed double layer pad with a concentric groove
Polishing pressure: 25 kPa
Platen rotation number: 98 min⁻¹
Polishing slurry flow rate: 200 ml/min
Polishing time: 1 min

### <Evaluation item and evaluation method>

Silicon oxide polishing rate by CMP: Difference in the film thickness of the substrate 1 before and after CMP was determined with an optical film thickness measuring device.

Polysilicon polishing rate by CMP: Difference in the film thickness of the substrate 2 before and after CMP was determined with an optical film thickness measuring device.

The results of the evaluation indicate that the polishing rate for a silicon oxide film was 160 nm/min, the polishing rate for a polysilicon was 0.7 nm/min, and the ratio of the polishing rate for a silicon oxide film to the polishing rate for a polysilicon film was 228.

### Example 2

The polishing rates for a silicon oxide film and a polysilicon film were evaluated using a polishing slurry of the polishing slurry 2 under the same conditions as Example 1. The results of the evaluation indicate that the polishing rate for a silicon oxide film was 250 nm/min, the polishing rate for a polysilicon was 1.5 nm/min, and the ratio of the polishing rate for a silicon oxide film to the polishing rate for a polysilicon film was 167.

### Example 3

The polishing rates for a silicon oxide film and a polysilicon film were evaluated using a polishing slurry of the polishing slurry 3 under the same conditions as Example 1. The results of the evaluation indicate that the polishing rate for a silicon oxide film was 90 nm/min, the polishing rate for a polysilicon was 3.5 nm/min, and the ratio of the polishing rate for a silicon oxide film to the polishing rate for a polysilicon film was 26.

### Example 4

The polishing rates for a silicon oxide film and a polysilicon film were evaluated using a polishing slurry of the polishing slurry 4 under the same conditions as Example 1. The results of the evaluation indicate that the polishing rate for a silicon oxide film was 270 nm/min, the polishing rate for a polysilicon was 1.2 nm/min, and the ratio of the polishing rate for a silicon oxide film to the polishing rate for a polysilicon film was 225.

### Example 5

The polishing rates for a silicon oxide film and a polysilicon film were evaluated using a polishing slurry of the polishing slurry 5 under the same conditions as Example 1. The results of the evaluation indicate that the polishing rate for a silicon oxide film was 250 nm/min, the polishing rate for a polysilicon was 1 nm/min, and the ratio of the polishing rate for a silicon oxide film to the polishing rate for a polysilicon film was 250.

### Example 6

The polishing rates for a silicon oxide film and a polysilicon film were evaluated using a polishing slurry of the polishing slurry 6 under the same conditions as Example 1. The results of the evaluation indicate that the polishing rate for a silicon oxide film was 200 nm/min, the polishing rate for a polysilicon was 1.5 nm/min, and the ratio of the polishing rate for a silicon oxide film to the polishing rate for a polysilicon film was 133.

### Example 7

The polishing rates for a silicon oxide film and a polysilicon film were evaluated using a polishing slurry of the polishing slurry 7 under the same conditions as Example 1. The results of the evaluation indicate that the polishing rate for a silicon oxide film was 190 nm/min, the polishing rate for a polysilicon was 1.1 nm/min, and the ratio of the polishing rate for a silicon oxide film to the polishing rate for a polysilicon film was 173.

### Example 8

The polishing rates for a silicon oxide film and a polysilicon film were evaluated using a polishing slurry of the polishing slurry 8 under the same conditions as Example 1. The results of the evaluation indicate that the polishing rate for a silicon oxide film was 160 nm/min, the polishing rate for a polysilicon was 0.8 nm/min, and the ratio of the polishing rate for a silicon oxide film to the polishing rate for a polysilicon film was 200.

### Example 9

The polishing rates for a silicon oxide film and a polysilicon film were evaluated using a polishing slurry of the polishing slurry 3 under the same conditions as Example 1. The results of the evaluation indicate that the polishing rate for a silicon oxide film was 170 nm/min, the polishing rate for a polysilicon was 1 nm/min, and the ratio of the polishing rate for a silicon oxide film to the polishing rate for a polysilicon film was 170.

### Example 10

The polishing rates for a silicon oxide film and a polysilicon film were evaluated using a polishing slurry of the polishing slurry 10 under the same conditions as Example 1. The results of the evaluation indicate that the polishing rate for a silicon oxide film was 180 nm/min, the polishing rate for a polysilicon was 1 nm/min, and the ratio of the polishing rate for a silicon oxide film to the polishing rate for a polysilicon film was 180.

### Example 11

The polishing rates for a silicon oxide film and a polysilicon film were evaluated using a polishing slurry of the polishing slurry 11 under the same conditions as Example 1. The results of the evaluation indicate that the polishing rate for a silicon oxide film was 180 nm/min, the polishing rate for a polysilicon was 2 nm/min, and the ratio of the polishing rate for a silicon oxide film to the polishing rate for a polysilicon film was 90.

### Example 12

The polishing rates for a silicon oxide film and a polysilicon film were evaluated using a polishing slurry of the polishing slurry 12 under the same conditions as Example 1. The results of the evaluation indicate that the polishing rate for a silicon oxide film was 150 nm/min, the polishing rate for a polysilicon was 1 nm/min, and the ratio of the polishing rate for a silicon oxide film to the polishing rate for a polysilicon film was 150.

### Comparative Example 1

The polishing rates for a silicon oxide film and a polysilicon film were evaluated using a polishing slurry of the polishing slurry 13 under the same conditions as Example 1. The results of the evaluation indicate that the polishing rate for a silicon oxide film was 410 nm/min, the polishing rate for a polysilicon was 90 nm/min, and the ratio of the polishing rate for a silicon oxide film to the polishing rate for a polysilicon film was 4.6.

### Comparative Example 2

The polishing rates for a silicon oxide film and a polysilicon film were evaluated using a polishing slurry of the polishing slurry 14 under the same conditions as Example 1. The results of the evaluation indicate that the polishing rate for a silicon oxide film was 260 nm/min, the polishing rate for a polysilicon was 60 nm/min, and the ratio of the polishing rate for a silicon oxide film to the polishing rate for a polysilicon film was 4.3.

### Example 13

The polishing rates for a silicon oxide film and a polysilicon film were evaluated using a polishing slurry of the polishing slurry 15 under the same conditions as Example 1. The results of the evaluation indicate that the polishing rate for a silicon oxide film was 22 nm/min, the polishing rate for a polysilicon was 0.8 nm/min, and the ratio of the polishing rate for a silicon oxide film to the polishing rate for a polysilicon film was 27.5.

### Example 14

The polishing rates for a silicon oxide film and a polysilicon film were evaluated using a polishing slurry of the polishing slurry 16 under the same conditions as Example 1. The results of the evaluation indicate that the polishing rate for a silicon oxide film was 280 nm/min, the polishing rate for a polysilicon was 35 nm/min, and the ratio of the polishing rate for a silicon oxide film to the polishing rate for a polysilicon film was 8.0.

### Comparative Example 3

The polishing rates for a silicon oxide film and a polysilicon film were evaluated using a polishing slurry of the polishing slurry 17 under the same conditions as Example 1. The results of the evaluation indicate that the polishing rate for a silicon oxide film was 435 nm/min, the polishing rate for a polysilicon was 75 nm/min, and the ratio of the polishing rate for a silicon oxide film to the polishing rate for a polysilicon film was 5.8.

### Comparative Example 4

The polishing rates for a silicon oxide film and a polysilicon film were evaluated using a polishing slurry of the polishing slurry 18 under the same conditions as Example 1. The results of the evaluation indicate that the polishing rate for a silicon oxide film was 432 nm/min, the polishing rate for a polysilicon was 110 nm/min, and the ratio of the polishing rate for a silicon oxide film to the polishing rate for a polysilicon film was 3.9. Tables 1 through 3 show the polishing rate and polishing rate ratio of Examples and Comparative Examples.

**[Table 1]**

| | Ex. 1 | Ex. 2 | Ex. 3 | Ex. 4 | Ex. 5 | Ex. 6 | Ex. 7 |
|---|---|---|---|---|---|---|---|
| Polishing slurry | 1 | 2 | 3 | 4 | 5 | 6 | 7 |
| Cerium oxide (5wt%) | 600 | 600 | 600 | 600 | 600 | 600 | 600 |
| Water-soluble polymer 1 | 1 | - | 0.5 | - | - | - | - |
| Water-soluble polymer 2 | - | 2 | - | - | - | - | - |
| Water-soluble polymer 3-1 | - | - | - | 20 | - | - | - |
| Water-soluble polymer 3-2 | - | - | - | - | 20 | - | - |
| Water-soluble polymer 3-3 | - | - | - | - | - | 20 | - |
| Water-soluble polymer 3-4 | - | - | - | - | - | - | 20 |
| Water-soluble polymer 7 | - | - | 70 | - | - | - | - |
| Deionized water pH | 2399 6.5 | 2398 6.5 | 2329.5 6.5 | 2380 6.5 | 2380 6.5 | 2380 6.5 | 2380 6.5 |
| Polishing rate for silicon oxide (nm/minute) | 160 | 250 | 90 | 270 | 250 | 200 | 190 |
| Polishing rate for polysilicon (nm/minute) | 0.7 | 1.5 | 3.5 | 1.2 | 1 | 1.5 | 1.1 |
| Polishing rate ratio of silicon oxide to polysilicon | 228 | 167 | 26 | 225 | 250 | 133 | 173 |

**[Table 2]**

| | Ex. 8 | Ex. 9 | Ex. 10 | Ex. 11 | Ex. 12 |
|---|---|---|---|---|---|
| Polishing slurry | 8 | 9 | 10 | 11 | 12 |
| Cerium oxide (5wt%) | 600 | 600 | 600 | 600 | 600 |
| Water-soluble polymer 1 | - | - | - | - | - |
| Water-soluble polymer 2 | - | - | - | - | - |
| Water-soluble polymer 3-1 | 10 | - | - | - | - |
| Water-soluble polymer 3-2 | - | - | - | - | - |
| Water-soluble polymer 3-3 | - | - | - | - | - |
| Water-soluble polymer 3-4 | - | 10 | - | - | - |
| Water-soluble polymer 4 | - | - | 5 | - | - |
| Water-soluble polymer 5 | - | - | - | 5 | - |
| Water-soluble polymer 6 | - | - | - | - | 5 |
| Water-soluble polymer 7 | 70 | 70 | 70 | 70 | 70 |
| Deionized water | 2320 | 2320 | 2325 | 2325 | 2325 |
| pH | 6.5 | 6.5 | 6.5 | 6.5 | 6.5 |
| Polishing rate for silicon oxide (nm/minute) | 160 | 170 | 180 | 180 | 150 |
| Polishing rate for polysilicon (nm/minute) | 0.8 | 1 | 1 | 2 | 1 |
| Polishing rate ratio of silicon oxide to polysilicon | 200 | 170 | 180 | 90 | 150 |

**[Table 3]**

| | Comp. Ex. 1 | Comp. Ex. 2 | Ex. 13 | Ex. 14 | Comp. Ex. 3 | Comp. Ex. 4 |
|---|---|---|---|---|---|---|
| Polishing slurry | 13 | 14 | 15 | 16 | 17 | 18 |
| Cerium oxide (5wt%) | 600 | 600 | 600 | 600 | 600 | 600 |
| Water-soluble polymer 1 | - | - | - | - | - | - |
| Water-soluble polymer 2 | - | - | - | - | - | - |
| Water-soluble polymer 3-1 | - | - | 12 | 60 | - | - |
| Water-soluble polymer 3-2 | - | - | - | - | - | - |
| Water-soluble polymer 3-3 | - | - | - | - | - | - |
| Water-soluble polymer 3-4 | - | - | - | - | - | - |
| Water-soluble polymer 7 | - | 70 | - | - | - | - |
| Deionized water | 2400 | 2330 | 2388 | 2340 | 2400 | 2400 |
| pH | 6.5 | 6.5 | 4.5 | 9.0 | 4.5 | 9.0 |
| Polishing rate for silicon oxide (nm/minute) | 410 | 260 | 22 | 280 | 435 | 432 |
| Polishing rate for polysilicon (nm/minute) | 90 | 60 | 0.8 | 35 | 75 | 110 |
| Polishing rate ratio of silicon oxide to polysilicon | 4.6 | 4.3 | 27.5 | 8.0 | 5.8 | 3.9 |

Examples 1 through 14 of the invention exhibited a high polishing rate for a silicon oxide film and a low polishing rate for polysilicon, and achieved a sufficiently large polishing rate ratio between a silicon oxide film and polysilicon, wherein polysilicon is applicable as a stopper. The polishing rate for an oxide film was rather low at pH 4.5 in Example 13, and the polishing rate for a polysilicon film was rather high at pH 9 in Example 14, indicating that higher practicality is achieved in the range of pH 5 to 8. On the other hand, in Comparative Examples 1, 3, and 4 in which no polysilicon polishing inhibitor was used, the polishing rate for a silicon oxide film was high, but the polishing rate for polysilicon was also high, wherein polysilicon is inapplicable as a stopper. In Comparative Example 2 in which no polysilicon polishing inhibitor was used but an additive was used, the polishing rate for polysilicon was so high that the polishing rate ratio between a silicon oxide film and polysilicon was not large.

As described above, the invention provides a polishing slurry and a polishing method which are capable of polishing a silicon oxide film on a polysilicon film at a high speed, and inhibiting the progress of polishing of a polysilicon film in exposed parts in a CMP technique in the manufacturing process of a semiconductor in which a silicon oxide film is polished.

### Industrial Applicability

The invention provides a polishing slurry and a polishing method which are capable of polishing a silicon oxide film on a polysilicon film at a high speed, and inhibiting the progress of polishing of a polysilicon film in exposed parts in a CMP technique in the manufacturing process of a semiconductor in which a silicon oxide film is polished.

## Claims

1. Use of a polishing slurry in a method of polishing a silicon oxide film on polysilicon, wherein the polishing slurry contains an abrasive, a polysilicon polishing inhibitor, and water, wherein the polysilicon polishing inhibitor is either an oxyethylene adduct of an acetylene-based diol or the compound represented by the following general formula (III):
R¹-C=C-R² (III)
(in the general formula (III), R¹ represents a hydrogen atom or a substituted or unsubstituted alkyl group having 1 to 5 carbon atoms, R² represents a substituted or unsubstituted alkyl group having 4 to 10 carbon atoms).

2. The use of a polishing slurry according to claim 1, wherein the oxyethylene adduct of an acetylene-based diol is the compound represented by the following general formula (IV): 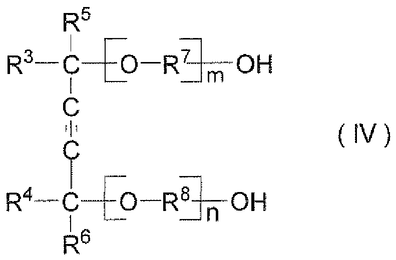 (in the general formula (IV), R³ to R⁶ each independently represent a hydrogen atom or a substituted or unsubstituted alkyl group having 1 to 5 carbon atoms, R⁷ and R⁸ each independently represent a substituted or unsubstituted alkylene group having 1 to 5 carbon atoms, and m and n each independently represent 0 or a positive number).

3. The use of a polishing slurry according to claim 1, wherein the polysilicon polishing inhibitor further includes one or more compounds selected from polyethylene glycol, an alkoxylated linear aliphatic alcohol and polyvinyl pyrrolidone or a copolymer containing vinyl pyrrolidone.

4. The use of a polishing slurry according to claim 1, wherein the content of the polysilicon polishing inhibitor is 0.005 % by mass or more and 2 % by mass or less.

5. The use of a polishing slurry according to claim 1, wherein the pH of the polishing slurry is 5.0 to 8.0.

6. The use of a polishing slurry according to claim 1, wherein the polishing slurry contains at least one selected from polyacrylic acid, polyacrylate, and a copolymer containing acrylate.

7. The use of a polishing slurry according to claim 1, wherein the abrasive contains cerium oxide.

8. The use of a polishing slurry according to claim 6, wherein the content of at least one selected from polyacrylic acid, polyacrylate, and a copolymer containing acrylate is 0.01 to 5 % by mass.

9. The use of a polishing slurry according to any of claims 1 to 3, 7 and 8, wherein the abrasive contains silicon oxide.

10. The use of a polishing slurry according to claim 1, wherein the use is in a polishing method, wherein the object to be polished is held against a polishing pad with the surface thereof to be polished facing the polishing pad, and polished by being slid relative to the polishing pad while the polishing slurry is supplied between the polishing pad and the surface to be polished.

11. The use of a polishing slurry according to claim 1, wherein the ratio of the polishing rate for silicon oxide to that for polysilicon is 10 or more.
